# EUROPEAN PATENT SPECIFICATION

(11) **EP 0 460 416 B1**
(45) Date of publication and mention of the grant of the patent: **21.08.1996**
(21) Application number: 91107338.5
(22) Date of filing: 06.05.1991
(51) Int. Cl.: G03F 7/039

(54) **Positive resist composition**
Positivresistzusammensetzung
Composition de réserve positive

(30) Priority: 05.06.1990 JP 147737/90
(43) Date of publication of application: 11.12.1991
(73) Proprietor: SUMITOMO CHEMICAL COMPANY, LIMITED, Chuo-ku Osaka 541 (JP)
(72) Inventor: Uetani, Yasunori, Toyonaka-shi, Osaka-fu (JP); Osaki, Haruyoshi, Toyonaka-shi, Osaka-fu (JP); Takeyama, Naoki, Settsu-shi, Osaka-fu (JP)
(74) Representative: VOSSIUS & PARTNER

(56) References cited:
- JP-B- 153 292

## Description

The present invention relates to a positive resist composition which is excellent in sensitivity, heat resistance and film thickness retention.

A radiation-sensitive resist composition containing a compound having a quinone diazide group finds use as a positive resist, because upon exposure to light having a wavelength of not longer than 500 nm, the quinone diazide group decomposes to form a carboxyl group whereby the originally alkali-insoluble composition becomes alkali-soluble. The positive resist composition has much better resolution than a negative resist composition and is used in the production of integrated circuits such as IC or LSI.

Recently, particularly in the production of integrated circuits, miniaturization has proceeded as the integration level has increased, which results in demands for formation of patterns of submicron order. According to conventional processes for the production of integrated circuits, light exposure is accomplished by placing a mask in intimate contact to a substrate, e.g. a silicon wafer. It is said that this process cannot make patterns thinner than 2 µm. Instead of such conventional processes, the reduction projection in exposure system attracts attention. According to this new system, a pattern of a master mask (reticle) is projected on the substrate with reduction by a lens system, whereby exposure is accomplished. This system realizes a resolving power of submicron.

One of the serious problems in this system is low throughput. Namely, in this system, the total exposure time to expose a wafer is very long because of divided and repeated light exposure unlike a batch light exposure system which is employed in the conventional mask contact printing methods.

To solve this problem, not only an improvement in the apparatus but also an increase in sensitivity of the resist to be used are important.

To increase the sensitivity, a molecular weight of an alkali-soluble resin is decreased. However, the decrease of the alkali-soluble resin molecular weight deteriorates heat resistance.

One of other measures to increase the sensitivity of the resist is selection of a monomer of the alkali-soluble resin so as to increase a dissolving rate of the resin in an alkaline developing solution. For example, in case of a novolak resin, when a ratio of a monomer which is highly soluble in the alkali developing solution such as m-cresol or phenol increases, the dissolving rate of the resin in the developing solution can be increased.

By the above measure, though the sensitivity of the photoresist is increased without deterioration of heat resistance and also without decreasing the molecular weight of the alkali-soluble resin, film thickness retention is deteriorated, which results in decrease of resolution.

In general, it is impossible to improve the sensitivity with maintaining heat resistance and the film thickness retention, and vice versa.

An object of the present invention is to provide a positive resist composition which has better heat resistance without deterioration of sensitivity and film thickness retention.

The present invention is based on the finding that, when a novolak resin prepared by a condensation reaction of an aldehyde with a compound of the following general formula (I) is used as an alkali-soluble resin in a positive resist composition, the heat resistance can be much improved without deterioration of sensitivity and film thickness retention.

According to the present invention, there is provided a positive resist composition comprising a radiation-sensitive compound and an alkali-soluble resin which is obtainable by a condensation reaction of an aldehyde and a compound of the formula: 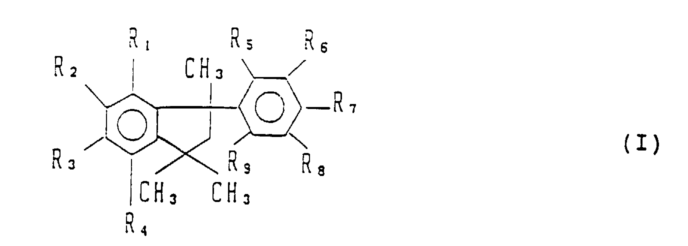 wherein R₁ to R₉ are the same or different and independently a hydrogen atom, an alkyl group, a halogen atom or a hydroxyl group, provided that at least one of R₁ to R₉ is a hydroxyl group and at least two of them at ortho- and para-positions to said at least one hydroxyl group are hydrogen atoms.

As the radiation-sensitive compound, a quinone diazide compound is used. The quinone diazide compound is prepared by a conventional method, for example, by a condensation reaction of naphthoquinone diazide sulfonyl chloride or benzoquinone diazide sulfonyl chloride (e.g naphthoquinone-(1,2)-diazide-(2)-5-sulfonyl chloride, naphthoquinone-(1,2)-diazide-(2)-4-sulfonyl chloride or benzoquinone-(1,2)-diazide-(2)-4-sulfonyl chloride) with a compound having a hydroxyl group in the presence of a weak alkali.

Examples of the compound having a hydroxyl group are hydroquinone, resorcinol, phloroglucin, 2,4-dihydroxybenzophenone, trihydroxybenzophenones (e.g. 2,3,4-trihydroxybenzophenone, 2,2',3-trihydroxybenzophenone, 2,2',4-trihydroxybenzophenone, 2,2',5-trihydroxybenzophenone, 2,3,3'-trihydroxybenzophenone, 2,3,4'-trihydroxybenzophenone, 2,3',4-trihydroxybenzophenone, 2,3',5-trihydroxybenzophenone, 2,4,4'-trihydroxybenzophenone, 2,4',5-trihydroxybenzophenone, 2',3,4-trihydroxybenzophenone, 3,3',4-trihydroxybenzophenone, 3,4,4'-trihydroxybenzophenone), tetrahydroxybenzophenones (e.g. 2,3,3',4-tetrahydroxybenzophenone, 2,3,4,4'-tetrahydroxybenzophenone, 2,2',4,4'-tetrahydroxybenzophenone, 2,2',3,4- tetrahydroxybenzophenone, 2,2',3,4'-tetrahydroxybenzophenone, 2,2',5,5'-tetrahydroxybenzophenone, 2,3',4',5-tetrahydroxybenzophenone, 2,3',5,5'-tetrahydroxybenzophenone), pentahydroxybenzophenones (e.g. 2,2',3,4,4'-pentahydroxybenzophenone, 2,2',3,4,5'-pentahydroxybenzophenone, 2,2',3,3',4-pentahydroxybenzophenone, 2,3,3',4,5'-pentahydroxybenzophenone), hexahydroxybenzophenones (e.g. 2,3,3',4,4',5'-hexahydroxybenzophenone, 2,2',3,3',4,5'-hexahydroxybenzophenone), alkyl gallates, and hydroflavan compounds such as a compound of the formula: 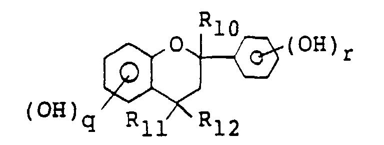 wherein q is a number of 0 to 4, r is a number of 1 to 5, provided that a sum of q and r is 2 or larger, R₁₀, R₁₁ and R₁₂ are respectively a hydrogen atom, an alkyl group, an alkenyl group, a cyclohexyl group or an aryl group.

The alkali-soluble resin to be used in the present invention is prepared by condensating the compound (I) with an aldehyde in the presence of an acid catalyst.

Examples of the aldehyde to be used are formaldehyde, paraformaldehyde, acetaldehyde, propylaldehyde, benzaldehyde, phenylacetaldehyde, α-phenylpropylaldehyde, β-phenylpropylaldehyde, o-hydroxybenzaldehyde, m-hydroxybenzaldehyde, p-hydroxybenzaldehyde, glutaraldehyde, glyoxal, o- methylbenzaldehyde and p-methylbenzaldehyde. Among them, formaldehyde is preferred since it is easily available in a commercial scale. They may be used alone or as a mixture of them.

The addition condensation reaction of the compound (I) and the aldehyde is carried out by a conventional method. The reaction is usually carried out at a temperature of 60 to 120°C for 2 to 30 hours.

As a catalyst, any of conventionally used organic acids, inorganic acid and divalent metal salts can be used. Specific examples of the acid catalyst are oxalic acid, hydrochloric acid, sulfuric acid, perchloric acid, p-toluenesulfonic acid, trichloroacetic acid, phosphoric acid, formic acid, zinc acetate and magnesium acetate.

The condensation reaction may be carried out in the presence or absence of a solvent.

Usually, the alkali-soluble resin has a weight average molecular weight (Mw) of 2000 to 50,000, preferably 3000 to 30,000 as measured by gel permeation chromatography (GPC).

The compound (I) may be synthesized from m- or p-isopropenylbenzene or its linear dimer by a method disclosed in US-A-3,288,864.
As the alkyl group for R₁ to R₉, a straight or branched C₁-C₇ alkyl group, especially C₁-C₄ alkyl group is preferred. Preferred examples of the alkyl group are a methyl group and an ethyl group. Examples of the halogen atom are a fluorine atom, a chlorine atom, a bromine atom and an iodine atom.

Preferred examples of the compound (I) are as follows:

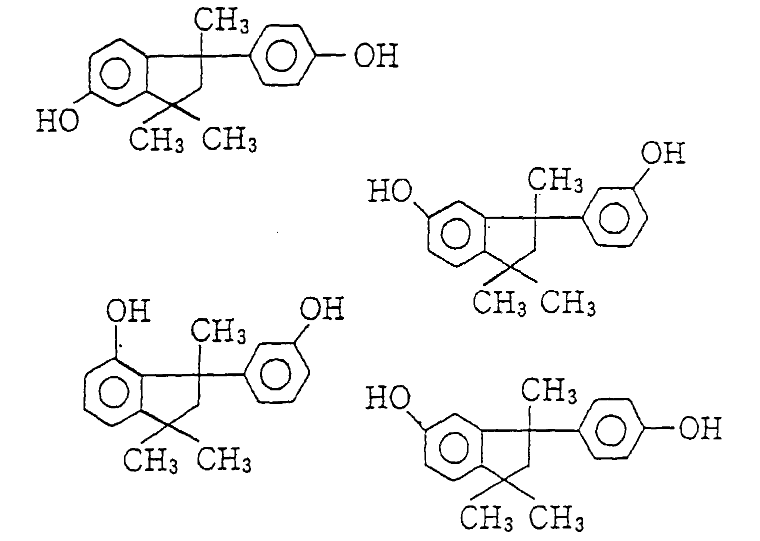

The compounds (I) may be used alone or as a mixture thereof.

The positive resist composition is prepared by mixing and dissolving the radiation-sensitive compound and the alkali-soluble resin in a solvent. A weight ratio of the alkali-soluble resin to the radiation-sensitive compound is preferably from 1:1 to 6:1.

Preferably, the used solvent evaporates at a suitable drying rate to give a uniform and smooth coating film. Examples of such solvent are ethylcellosolve acetate, methylcellosolve acetate, ethylcellosolve, methylcellosolve, propyleneglycol monomethyl ether acetate, butyl acetate, methyl isobutyl ketone, xylene, ethyl lactate and propyleneglycol monoethyl ether. In case of ethylcellosolve acetate, the solvent is used in an amount of 30 to 80 % by weight of the all solvent weight.

To the positive resist composition obtained by the foregoing method, small amounts of resins or dyes may be added if desired.

The resist composition of the present invention has improved sensitivity, heat resistance and the film thickness retention and is useful as a resist composition for KrF excimer laser.

The present invention will be illustrated more in detail with the following Examples, but it is not limited to these Examples. In Examples, "parts" are by weight unless otherwise indicated.

### Synthesis Example

In a 300 ml four-necked flask, a compound of the formula: 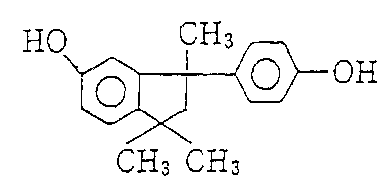 (p-OST Cyclic Dimer manufactured by Mitsui Toatsu) (53.6 g), ethylcellosolve acetate (50.4 g) and 5 % oxalic acid (6.08 g) were charged and heated to 80°C. Then, to the mixture, 37 % formalin (13.0 g) was dropwise added over 60 minutes while stirring, followed by stirring for 10 hours at 110°C.

Thereafter, the mixture was neutralized, washed with water and dehydrated to obtain a solution of a novolak resin in ethylcellosolve acetate. The obtained resin was designated as a resin A.

The resin A had a weight average molecular weight of 5500 (calculated as polystyrene) measured by GPC

### Example and Comparative Examples 1 and 2

Each resin was dissolved in ethylcellosolve acetate (48 parts) together with a quinone diazide compound in a composition shown in the Table.

The resulting solution was filtered through a Teflon (trademark) filter of 0.2 µm in pore size to obtain a resist solution. The solution was then coated on a silicon wafer, which had been rinsed in a usual manner, by means of a spinner to form a resist film of 1.3 µm in thickness. The coated silicon wafer was baked for 60 seconds on a hot plate kept at 100°C and exposed to light having a wavelength of 436 nm (g line) while varying the exposure time stepwise by means of a reduction projection exposure apparatus (NSR 1505 G 3C with NA = 0.42 manufactured by GCA). Thereafter, the silicon wafer was developed in a developer (SOPD (trade name) manufactured by Sumitomo Chemical Company, Limited) to obtain a positive pattern.

The remaining film thicknesses of the resist were plotted against the exposure time to calculate sensitivity. The film thickness retention was calculated from the remaining film thickness in the unexposed area. Also, the silicon wafer having a resist pattern was placed for 3 minutes on a direct hot plate set at various temperatures, and the heat resistance was evaluated by observing occurrence of thermal deformation of a line and space pattern of 3 µm by means of a scanning electron microscope. The results are shown in the Table.

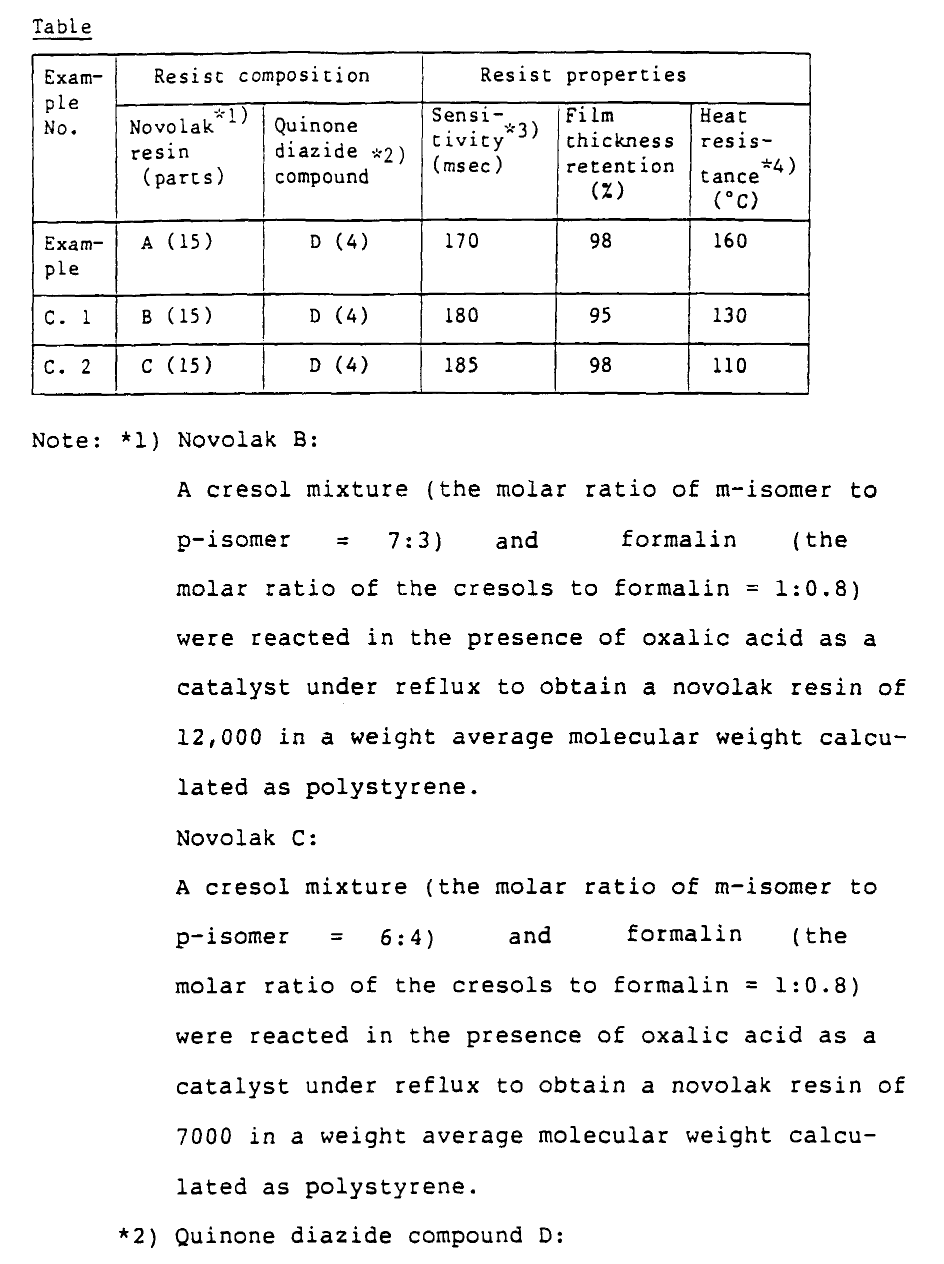

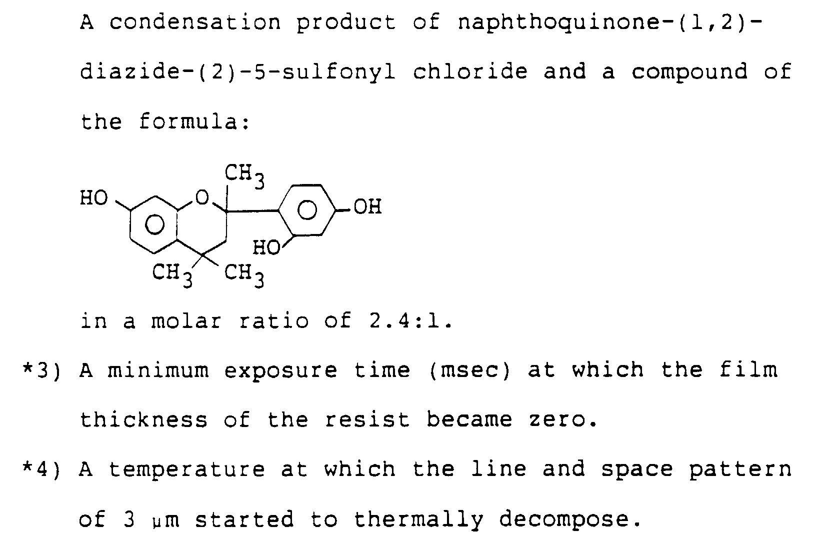

## Claims

1. A positive resist composition comprising a radiation-sensitive compound and an alkali-soluble resin which is obtainable by a condensation reaction of an aldehyde and a compound of the formula: 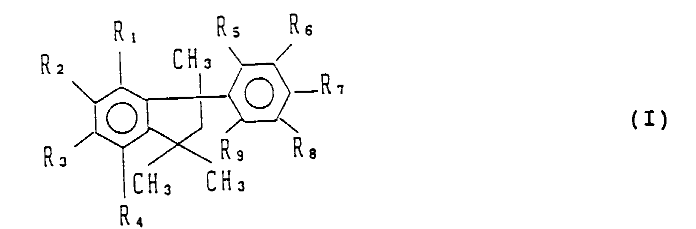 wherein R₁ to R₉ are the same or different and independently a hydrogen atom, an alkyl group, a halogen atom or a hydroxyl group, provided that at least one of R₁ to R₉ is a hydroxyl group and at least two of them at ortho- and para-positions to said at least one hydroxyl group are hydrogen atoms.

## Patentansprüche

1. Positivresistzusammensetzung, die eine Strahlungs-empfindfiche Verbindung und ein Alkali-lösliches Harz umfaßt, das durch Kondensationsreaktion eines Aldehyds und einer Verbindung der Formel: 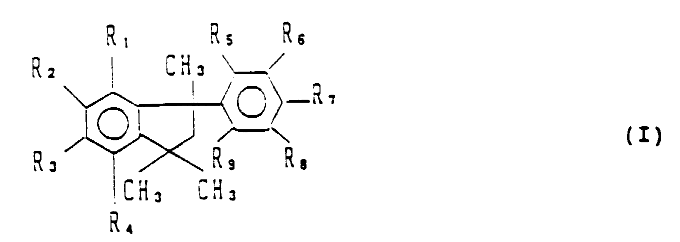 erhältlich ist, in der R₁ bis R₉ gleich oder verschieden sind und unabhängig voneinander ein Wasserstoffatom, einen Alkylrest, ein Halogenatom oder eine Hydroxylgruppe darstellen, vorausgesetzt, daß mindestens einer der Reste R₁ bis R₉ eine Hydroxylgruppe ist und mindestens zwei von ihnen in ortho- und para-Stellungen zu der mindestens einen Hydroxylgruppe Wasserstoffatome sind.

## Revendications

1. Composition de réserve positive comprenant un composé sensible aux radiations et une résine soluble dans les alcalis, qui peut être obtenue par une réaction de condensation d'un aldéhyde et d'un composé de la formule : 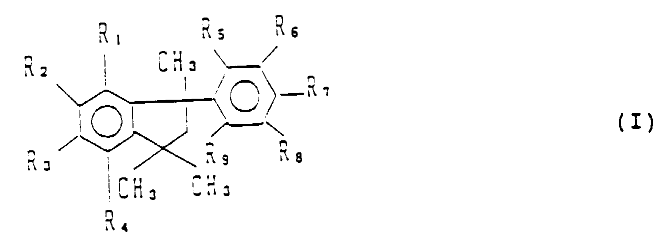 dans laquelle R₁ à R₉ sont identiques ou différents et indépendamment un atome d'hydrogène, un groupe alkyle, un atome d'halogène ou un groupe hydroxyle, à la condition qu'au moins l'un parmi R₁ à R₉ représente un groupe hydroxyle et qu'au moins deux d'entre eux dans les positions ortho et para par rapport audit (auxdits) groupe(s) hydroxyle représentent des atomes d'hydrogène.
